# FASCICULE DE BREVET EUROPEEN

(11) **EP 0 734 122 B1**
(45) Date de publication et mention de la délivrance du brevet: **17.12.2003**
(21) Numéro de dépôt: 96400579.7
(22) Date de dépôt: 20.03.1996
(51) Int. Cl.: H03K 3/3562

(54) **Elément de mémoire du type bascule maître-esclave, réalisé en technologie CMOS**
In CMOS-Technik ausgeführtes Speicherelement des Master-Slave-Typs
Memory element of the master-slave type implemented in CMOS-technology

(30) Priorité: 21.03.1995 FR 9503280
(43) Date de publication de la demande: 25.09.1996
(73) Titulaire: CSEM Centre Suisse d'Electronique et de Microtechnique SA -Recherche et Développement, 2007 Neuchâtel (CH)
(72) Inventeur: Piguet, Christian, 2000 Neuchatel (CH); Masgonty, Jean-Marc, 2074 Marin (CH)
(74) Mandataire: Caron, Gérard

(56) Documents cités:
- EP-A- 0 219 907
- EP-A- 0 225 075
- DE-A- 2 829 968
- DE-A- 2 830 045
- US-A- 4 057 741
- BULLETIN ANNUEL DE LA SOCIETE SUISSE DE CHRONOMETRIE ET DU LABORATOIRE SUISSE DE RECHERCHES HORLOGERES, vol. 7, no. 2, 1976, NEUCHATEL CH, pages 159-163, XP002006950 VITTOZ ET AL.: "Circuits C-MOS pseudo-aléatoires"
- IEEE JOURNAL OF SOLID-STATE CIRCUITS, vol. 26, no. 3, Mars 1991, NEW YORK US, pages 371-380, XP002006951 PIGUET: "Logis synthesis of race-free asynchronous CMOS circuits"

## Description

La présente invention est relative à un élément de mémoire formé par une bascule de type D appelée communément bascule maître-esclave. Plus particulièrement, l'invention concerne les bascules de type D et de type statique, c'est-à-dire ayant des états stables dans lesquels elles peuvent être placées sous la commande d'un signal d'horloge.

On sait que les bascules de type D sont destinées à transférer une variable logique d'entrée à leur sortie sous la commande d'un signal d'horloge. Ces bascules peuvent être à circuit simple et constituer ce que l'on appelle couramment un "verrou" (latch) ou encore être plus complexe et former une bascule dite "maître-esclave" (master-slave) dans laquelle en principe l'esclave recopie l'état du maître (déterminé en fonction de la variable d'entrée) sous la commande de l'un des états logiques du signal d'horloge.

Par US-A-4 057 741, on connaît une bascule maître-esclave (voir la figure 4 du document) dont la structure est dite semi-dynamique. Cela veut dire dans le cadre de la technologie concernée que la bascule fonctionne de façon dynamique, lorsque le signal d'horloge CK est à "1" et de façon statique seulement lorsque le signal d'horloge est à "0".

Cette bascule tire en fait partie de la faible durée du signal d'horloge à "1" qui est bien inférieure au temps de décharge des capacités des différents noeuds de la bascule. De la sorte, il est possible de supprimer plusieurs transistors dont la fonction serait de maintenir le potentiel de ces noeuds.

Cependant, si l'on veut s'affranchir de la contrainte d'utiliser une horloge rapide ayant un rapport déterminé avec le temps de décharge des capacités de cette bascule, il faudrait bien plus de transistors que ceux montrés dans le schéma de la figure 4 de ce document antérieur.

La présente invention vise à fournir un élément de mémoire du type maître-esclave dont l'un et l'autre états soient stables ce qui permet d'utiliser une horloge dont la rapidité ne dépend pas des capacités des noeuds du montage, et qui présente néanmoins un faible nombre de transistors.

Les spécialistes de la technologie CMOS connaissent par ailleurs également une topographie particulièrement efficace tant du point de vue de la consommation d'énergie, de la rapidité et de la régularité d'implantation, que de celui de l'encombrement sur le circuit intégré (c'est-à-dire grosso-modo du nombre nécessaire de transistors et de leurs interconnexions). Il s'agit de la topographie dite "en branches" dont le brevet suisse CH 629 921 donne l'une des premières descriptions. Dans une telle topographie, les transistors CMOS sont groupés suivant leur type canal P ou canal N dans des branches parallèles entre deux bornes d'alimentation V_{DD} et Vₛₛ, les noeuds de sortie des diverses portes logiques composant le circuit constituant des bornes délivrant les variables de ces éléments.

Cette technologie a déjà été utilisée pour les bascules du type D maître-esclave auxquelles l'invention s'adresse plus particulièrement.

L'une des préoccupations des concepteurs de ce genre de circuits logiques relève d'une propriété des circuits logiques d'avoir tendance à fournir parfois à leur sortie un état indéterminé en fonction des variables d'entrée. Cette propriété est appelée "course" (race) par les spécialistes et il s'agit naturellement, dans toute la mesure du possible, de l'éviter de telle façon que le circuit fournisse toujours, en fonction d'un jeu déterminé de ses variables d'entrée, un même état préférentiel à sa sortie. Si la configuration du circuit ne permet pas d'éviter totalement la course, l'on peut du moins l'orienter, à l'aide notamment d'un dimensionnement adéquat des transistors du circuit. Dans ce cas, les spécialistes parlent de "course critique".

La solution idéale serait évidemment de concevoir un circuit qui soit dépourvu totalement de "course" et qui présente en même temps les autres propriétés favorables que l'on souhaiterait lui conférer, telles par exemple qu'une très basse consommation, une grande rapidité de fonctionnement et un encombrement faible. Toutefois, il s'avère que ces qualités favorables sont essentiellement contradictoires et qu'il faut en fait chercher un compromis entre la "course" d'une part, et les autres qualités que l'on vient de mentionner, d'autre part.

L'invention a pour également pour but de fournir un élément de mémoire du type général évoqué ci-dessus qui permette d'obtenir le meilleur compromis possible de toutes les propriétés déterminantes que doit posséder un tel élément.

L'invention a donc pour objet un élément de mémoire du type bascule maître-esclave tel que revendiqué dans la revendication 1.

Des caractéristiques complémentaires avantageuses de cet élément de mémoire apparaissent dans les sous revendications 2 à 19.

L'invention a également pour but de fournir une application particulière de l'élément de mémoire tel que défini ci-dessus, dont la variable de sortie est la division par deux d'une variable logique d'entrée et dont la structure est légèrement plus simple.

Ainsi, l'invention a également pour objet un élément de mémoire du type bascule maître-esclave tel que défini dans la revendication 20.

D'autres caractéristiques complémentaires avantageuses de cette application apparaissent dans les sous-revendications 21 et 22.

D'autres caractéristiques et avantages de l'invention apparaîtront au cours de la description qui va suivre, donnée uniquement à titre d'exemple et faite en se référant aux dessins annexés sur lesquels:
- les figures 1A et 1B montrent un exemple de bascule maître-esclave du type D de la technique antérieure;
- les figures 2A et 2B montrent un premier exemple de réalisation d'une bascule maître-esclave du type D selon l'invention, cette version permettant de faire pencher le compromis évoqué plus haut vers un nombre réduit de transistors;
- les figures 3A et 3B montrent une variante de réalisation de la bascule des figures 2A et 2B, dans une version pouvant servir plus particulièrement pour constituer un diviseur par 2;
- les figures 4A et 4B montrent une autre variante de réalisation de la bascule D selon l'invention, cette bascule comportant une commande S en supplément;
- les figures 5A et 5B montrent un autre mode de réalisation de l'invention dans lequel le compromis évoqué ci-dessus penche en faveur d'une élimination totale de la course;
- les figures 6A et 6B montrent une variante de la bascule des figures 5A et 5B, comportant en supplément une commande R;
- les figures 7A et 7B montrent une autre variante de la bascule des figures 5A et 5B pourvue en supplément d'une commande S;
- les figures 8A à 10B montrent encore plusieurs autres variantes de la bascule suivant l'invention;
- les figures 11A et 11B montrent une variante du diviseur par 2 représenté sur les figures 3A et 3B.

Dans la description qui va suivre, chaque mode de réalisation de la bascule de l'invention et chacune de leurs variantes seront examinés à l'aide d'un premier schéma dit fonctionnel comportant les symboles habituels des portes logiques, et d'un second schéma dit "en branches" qui en montre plus particulièrement la topographie. Il est à noter que les caractéristiques illustrant l'invention se reflètent spécialement dans les seconds schémas des bascules, les schémas fonctionnels pouvant être dans certains cas identiques malgré une différence essentielle dans la topographie des bascules concernées.

Ceci étant, on admet par convention que les portes logiques utilisées sont désignées par leur variable de sortie sur les deux types de schémas. Par ailleurs, dans les seconds schémas, les différents transistors MOS ont été symbolisés par des cercles, à l'intérieur desquels on a inscrit la variable de commande appliquée à leur grille, les connexions dessinées étant celles de leur chemin de conduction.

En outre, les transistors connectés entre les noeuds de sortie et la borne positive (V_{DD}) de la source d'alimentation sont à canal P, tandis que les transistors connectés entre les noeuds de sortie et la borne négative (V_{SS}) de cette source sont à canal N. Par convention, les potentiels des bornes V_{DD} et V_{SS} sont désignées respectivement par 1 et 0, représentant également les niveaux logiques possibles des variables de commande de la bascule.

On notera également que les bascules décrites ci-après sont dites statiques, car les états dans lesquels elles sont placées sous la commande du signal d'horloge sont stables. On reconnaît cette propriété de ces bascules par le fait que les signaux de sortie sont rebouclés sur les entrées par des connexions physiquement présentes.

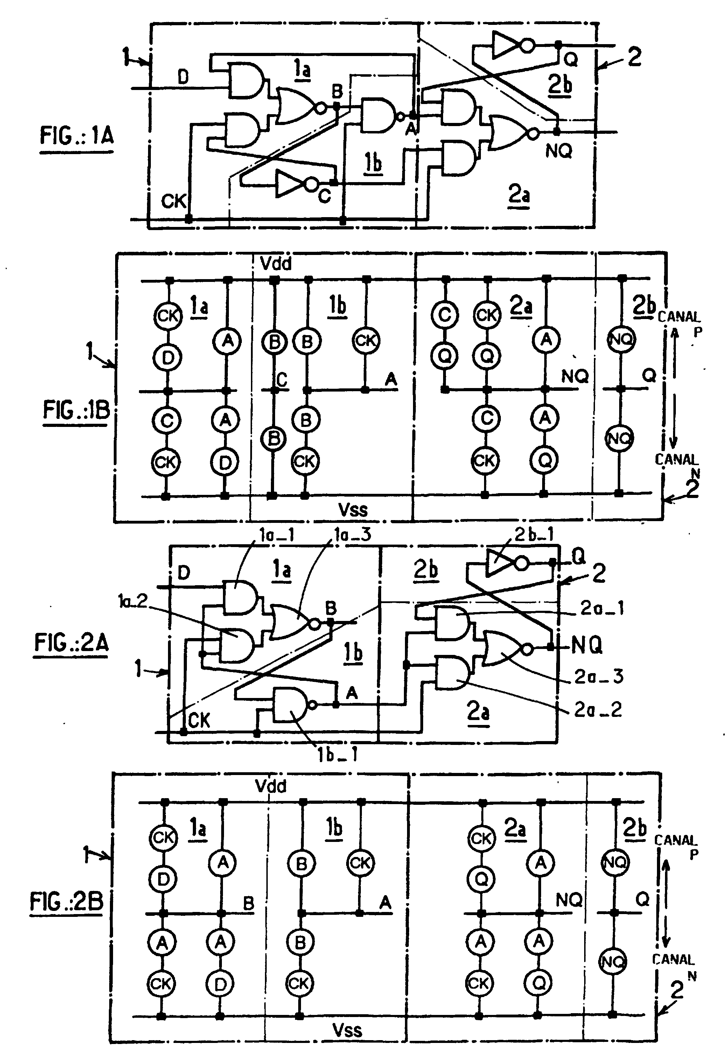

En se référant maintenant à la figure 1A, on a représenté une bascule de type D maître esclave selon la technique antérieure notamment divulguée lors de la conférence "PATMOS '94" à Barcelone par C. Piguet et al. sous le titre "Low Power, Low-Voltage Digital CMOS Cell Design". Cette bascule comporte un maître 1 et un esclave 2, tous deux entourés de traits mixtes gras, chacune de ces parties de la bascule comportant elle-même une première porte (resp. 1a et 2a) et une seconde porte séparées par un trait mixte fin (resp. 1b et 2b). Cette notation sera respectée dans l'ensemble des dessins pour tous les modes de réalisation de l'invention, ainsi que pour toutes leurs variantes. A ce stade de la description, on ne fera pas encore un examen détaillé du schéma de la bascule. Pour le moment, en se référant à la figure 1B, on notera que la porte 2a de l'esclave 2 (que l'on peut également appeler la porte NQ, c'est-à-dire celle délivrant la variable de sortie complémentée) comporte neuf transistors, ce qui est le prix à payer pour que cette bascule soit dépourvue de course.

On va maintenant examiner les figures 2A et 2B pour décrire un premier mode de réalisation de l'invention.

On retrouve le maître 1 et l'esclave 2, ainsi que les quatre portes 1a, 1b, 2a et 2b qui les composent. Selon le schéma fonctionnel de la figure 2A, la porte la comporte diverses portes élémentaires, à savoir une porte AND 1a-1 commandée par la variable D et la variable interne A, une porte AND 1a-2 commandée par la variable CK (c'est-à-dire l'horloge) et la variable interne A. Les sorties de ces deux portes sont appliquées comme entrées à une porte NOR 1a-3 qui délivre la variable interne B.

La porte 1b du maître 1 ne comporte ici qu'une seule porte élémentaire 1b-1 formée par une porte NAND qui reçoit sur ces entrées la variable CK et la variable interne B tout en délivrant sur sa sortie la variable interne A. Dans le présent mode de réalisation, cette variable A est la seule variable de transfert intervenant pour passer la variable d'entrée D à l'esclave 2.

La première porte 2a de l'esclave 2 comporte les portes élémentaires suivantes: une porte AND 2a-1 dont l'une des entrées est commandée par la variable interne A et dont la seconde entrée est raccordée à la sortie vraie Q de l'esclave, une porte AND 2a-2 dont l'une des entrées reçoit également la variable interne A et dont l'autre entrée est commandée par la variable CK, et une porte NOR 2a-3 qui reçoit les sorties des portes AND 2a-1 et 2a-2 et qui délivre la variable de sortie complémentaire NQ.

La seconde porte 2b de l'esclave 2 ne comporte qu'un seul circuit élémentaire, à savoir un inverseur 2b-1 qui reçoit sur son entrée la variable NQ et délivre à sa sortie la variable Q.

On notera que dans tous les modes de réalisation et des variantes de l'invention, les schémas fonctionnels de la première porte la du maître 1 et l'esclave 2 dans son ensemble sont identiques, tout au moins pour ce qui concerne leurs fonctions de base. Les éléments qui les composent sont donc, chaque fois, indiqués par les mêmes références comme décrites ci-dessus.

En examinant maintenant la figure 2B, on voit que la topographie de cette bascule est conçue comme suit:

| | | **Canal P** | **Canal N** |
|---|---|---|---|
| Porte 1a | groupe 1 | CK série D | A série CK |
| (B) | groupe 2 | A | A série D |
| | | | |
| Porte 1b | groupe 1 | B | B série CK |
| (A) | groupe 2 | CK | ---- |
| | | | |
| Porte 2a | groupe 1 | CK série Q | A série CK |
| (NQ) | groupe 2 | A | A série Q |
| | | | |
| Porte 2b | groupe 1 | NQ | NQ |
| (Q) | | | |

En comparant ce schéma en branches avec celui de la figure 1A, on constate que 1) l'un des transistors de la branche canal N du premier groupe dans la porte 1a est commandé par la variable A, au lieu de l'être par la variable C, 2) l'on se dispense d'utiliser un inverseur délivrant la variable C et 3) l'un des transistors de la branche canal N du premier groupe de la porte 2a est commandé par la variable A au lieu de l'être par la variable C.

En dressant la table d'état de cette bascule, on constate qu'elle présente deux courses critiques que l'on peut éliminer en dimensionnant les transistors de la bascule de telle façon que ces courses critiques soient toujours gagnées par la variable A au dépens de la variable B. Un tel dimensionnement ne pose pas de problèmes dans la mesure où la porte A (1b) est une simple porte NAND, A étant par ailleurs une variable interne de la bascule. En revanche, ce mode de réalisation présente l'avantage de la simplicité puisque seulement vingts transistors sont nécessaires pour le construire. On notera en particulier que la porte 2a de l'esclave 2 comporte sept transistors seulement. Dans ce ces, le compromis penche donc en faveur de la simplicité du circuit, une précaution devant être prise lors de la conception du circuit en ce qui concerne son dimensionnement.

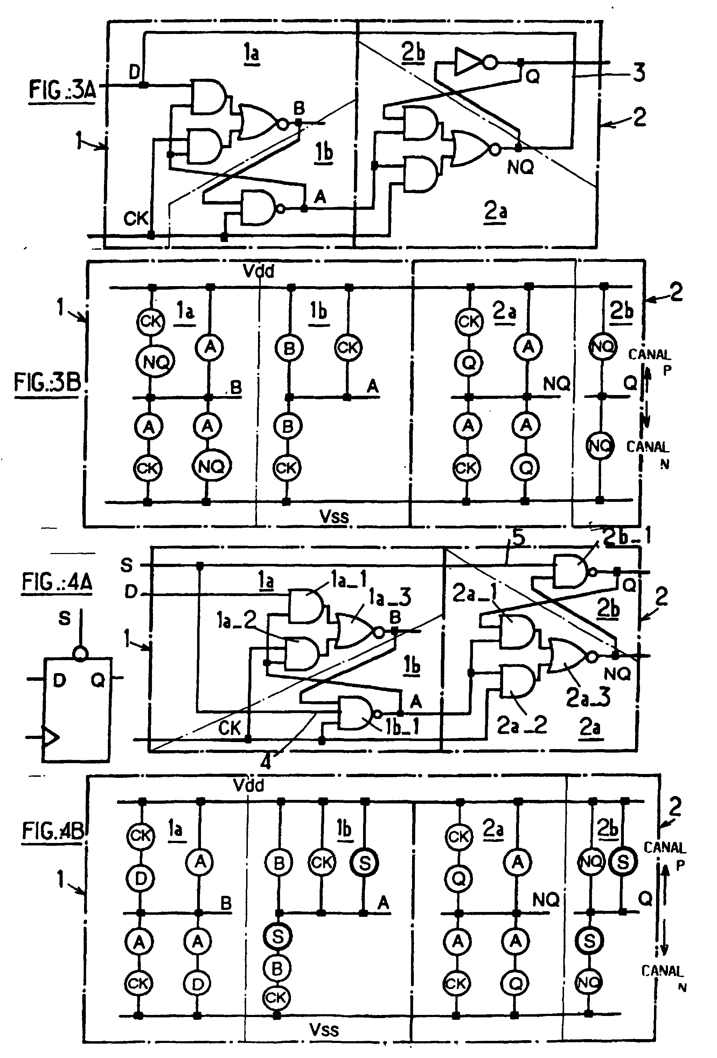

Les figures 3A et 3B montrent une variante du mode de réalisation que l'on vient de décrire, cette variante constituant un diviseur par 2. Pour obtenir cette fonction, la variable D commandant la porte la est en fait la variable de sortie complémentée, à savoir la variable NQ qui est appliquée à l'une des entrées de la porte élémentaire AND 1a-1, par l'intermédiaire d'une connexion 3 (figure 3A). On voit d'après le schéma en branches de la figure 3B que la porte la comporte alors un premier groupe canal P avec des transistors CK série NQ et un second groupe canal N avec des transistors A série NQ. Cette bascule comporte également vingt transistors et doit être dimensionnée convenablement pour éliminer la course, comme décrit ci-dessus à propos des figures 2A et 2B.

Le schéma en branches de cette variante est le suivant :

| | | **Canal P** | **Canal N** |
|---|---|---|---|
| Porte 1a | groupe 1 | CK série D | A série CK |
| (B) | groupe 2 | A | A série NQ |
| | | | |
| Porte 1b | groupe 1 | B | B série CK |
| (A) | groupe 2 | CK | ---- |
| | | | |
| Porte 2a | groupe 1 | CK série Q | A série CK |
| (NQ) | groupe 2 | A | A série Q |
| | | | |
| Porte 2b | groupe 1 | NQ | NQ |
| (Q) | | | |

Les figures 4A et 4B montrent une autre variante du mode de réalisation des figures 2A et 2B, ce circuit formant une bascule munie d'une commande de mise à "1" de la sortie Q par la variable S qui est active à l'état "O". Le schéma fonctionnel de cette bascule (figure 4A) montre que pour prendre en compte la variable S, la porte NAND 1b-1 comporte une entrée supplémentaire 4 commandée par la variable S. De même, l'inverseur 2b-1 qui constitue la porte 2b sur la figure 2A est remplacé par une porte NAND comportant une entrée 5 commandée également par la variable S.

Le schéma en branches de la figure 4B montre par ailleurs la conception suivante pour la topographie de cette bascule (les portes 1a et 2a restant inchangées):

| | | **Canal P** | **Canal N** |
|---|---|---|---|
| Porte 1a | groupe 1 | CK série D A | série CK |
| (B) | groupe 2 | A | A série D |
| | | | |
| Porte 1b | groupe 1 | B. | S série B série CK |
| (A) | groupe 2 | CK | ---- |
| | groupe 3 | S | ---- |
| Porte 2a | groupe 1 | CK série Q | A série CK |
| (NQ) | groupe 2 | A | A série Q |
| | | | |
| Porte 2b | groupe 1 | NQ | S série NQ |
| (Q) | groupe 2 | S | ---- |

On constate que cette bascule munie de la fonction S (SET) ne comporte que vingt quatre transistors, cependant qu'elle présente également deux courses critiques que l'on peut éviter par un dimensionnement convenable des transistors.

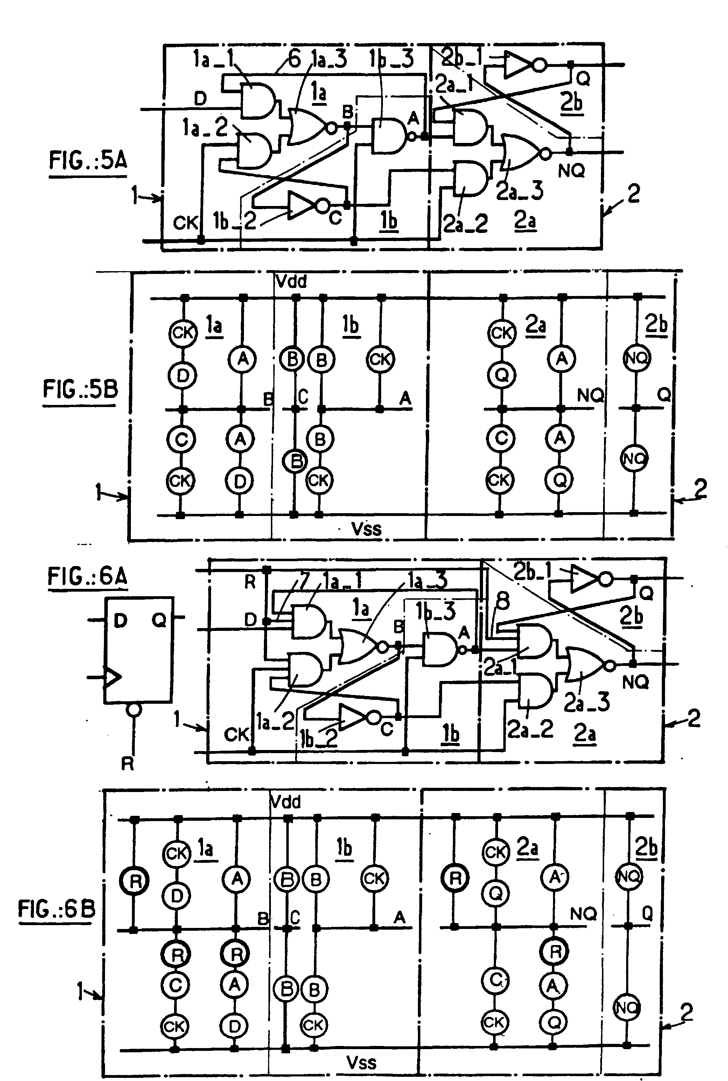

On va maintenant décrire un second mode de réalisation de l'invention en se référant aux figures 5A et 5B. Il diffère du mode de réalisation des figures 2A et 2B en ce que la porte 1b comporte deux circuits logiques élémentaires en remplacement de l'unique porte NAND 1b-1 représentée sur la figure 2A. Plus précisément, un inverseur 1b-2 délivrant la variable C est raccordé entre la sortie de la porte la et l'une des entrées de la porte élémentaire ET de la porte 1a. Cette inverseur délivre la variable C en tant que variable de transfert à la bascule esclave 2 sur l'une des entrées de la porte élémentaire ET 2a-2.

La porte 1b comporte également une porte élémentaire NAND 1b-3 dont l'une des entrées reçoit la variable B de la porte la et dont l'autre entrée est commandée par la variable CK. La sortie de la porte élémentaire NAND 1b-3 délivre la variable A qui est aussi une variable de transfert entre le maître 1 et l'esclave 2 et commande l'une des entrées de la porte élémentaire ET 2a-1 de la porte 2a. La variable A commande également l'une des entrées de la porte élémentaire 1a-1 par l'intermédiaire d'une connexion 6.

A priori, on pourrait dire que ce mode de réalisation de l'invention ne diffère pas du schéma de la bascule connue représenté sur les figures 1A et 1B. C'est vrai pour ce qui concerne le schéma fonctionnel des figures 1A et 5A. Cependant, en examinant les schémas en branches des figures 1B et 5B, l'on s'aperçoit que la réalisation de la porte 2a est différente en ce qu'elle est dépourvue de la branche canal P du premier groupe de transistors C et Q que l'on retrouve dans le schéma en branches de l'art antérieur.

Par conséquent, selon le mode de réalisation de l'invention représenté sur la figure 5B, la porte 2a de l'esclave peut être réalisée avec sept transistors seulement au lieu de neuf dans l'art antérieur. Or, il s'est avéré que l'élimination des deux transistors en question supprime toute course lors du fonctionnement de la bascule maître-esclave des figures 5A et 5B. Pour le dimensionnement des transistors de cette bascule, le concepteur dispose donc d'une plus grande souplesse puisque il n'a pas à tenir compte de la course. Le schéma en branches présente donc la forme suivante :

| | | | **Canal P** | **Canal N** |
|---|---|---|---|---|
| Porte 1a | groupe 1 | | CK série D | C série CK |
| (B) | groupe 2 | | A | A série D |
| | | | | |
| Porte 1b | groupe 1 | (C) | B | B |
| | | | | |
| | groupe 2 | (A) | B | B série CK |
| | groupe 3 | (A) | CK | ----- |
| | | | | |
| Porte 2a | groupe 1 | | CK série Q | C série CK |
| (NQ) | groupe 2 | | A | A série Q |
| | | | | |
| Porte 2b | groupe 1 | | NQ | NQ |
| (Q) | | | | |

Les figures 6A et 6B montrent une première variante du second mode de réalisation de l'invention, dans laquelle la bascule comporte en supplément une commande de mise à zéro de la sortie Q par la variable R qui est active à "0". A cet effet, la porte élémentaire ET 1a-1 comporte une troisième entrée 7 commandée par la variable R qui est également appliquée à l'esclave 2, à savoir à une troisième entrée 8 de la porte élémentaire ET 2a-1.

Le schéma en branches de la figure 6B montre une topographie particulière pour les portes la et 2a de cette bascule comparée au schéma en branches de la figure 5B, comme suit:

| | | | **Canal P** | **Canal N** |
|---|---|---|---|---|
| Porte 1a | groupe 1 | | R | ---- |
| (B) | groupe 2 | | CK série D | R série C série CK |
| | groupe 3 | | A | R série A série D |
| | | | | |
| Porte 1b | groupe 1 | (C) | B | B |
| | | | | |
| | groupe 2 | (A) | B | B série CK |
| | groupe 3 | (A) | CK | ----- |
| | | | | |
| Porte 2a | groupe 1 | | R | ----- |
| (NQ) | groupe 2 | | CK série Q | C série CK |
| | groupe 3 | | A | R série A série Q |
| | | | | |
| Porte 2b | groupe 1 | | NQ | NQ |
| (Q) | | | | |

Cette bascule est également dépourvue de course et elle est réalisée à l' aide de vingt sept transistors tout en comportant la commande par la variable R qui implique l'utilisation de cinq transistors. Un sixième transistor R peut être ajoutée éventuellement si l'on veut éviter un état transitoire dans lequel la porte NQ (2a) est en court-circuit avec CK=1. Ce transistor R doit alors être inséré dans la branche canal N du deuxième groupe de transistors de cette porte.

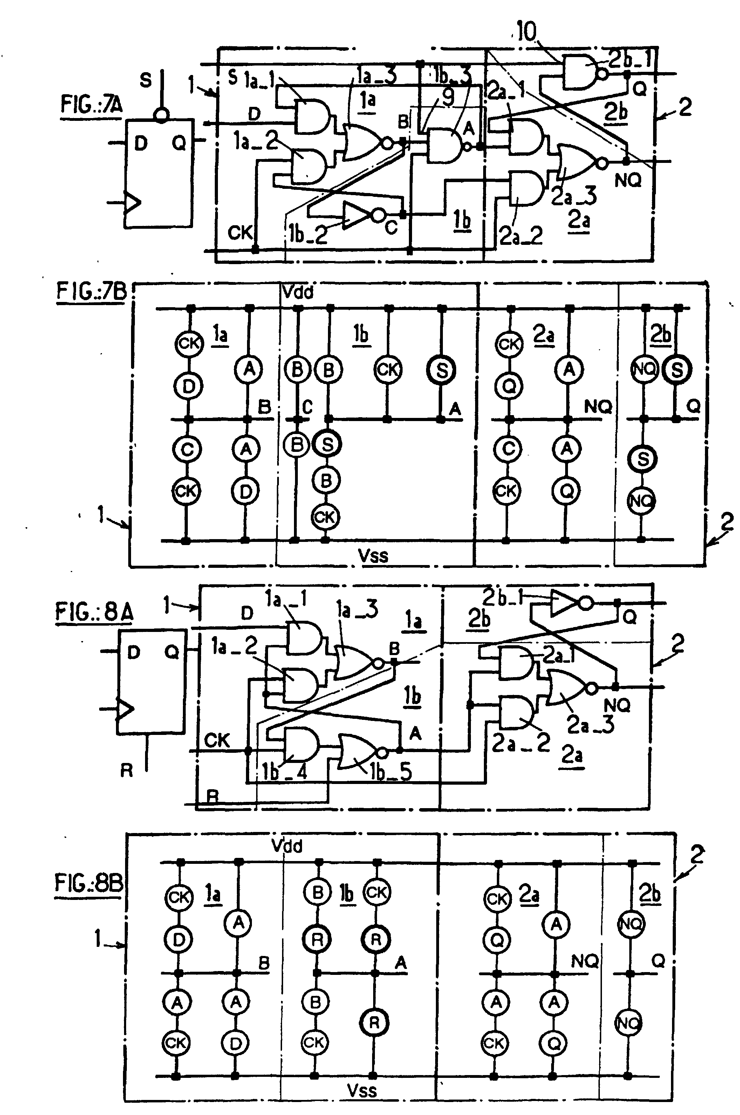

Les figures 7A et 7B montrent une seconde variante du second mode de réalisation de l'invention qui comporte une commande de mise à "1" du signal Q par la variable S active à "0". Celle-ci commande une troisième entrée 9 de la porte élémentaire NAND 1b-3. Par ailleurs, la porte 2b comporte ici une porte élémentaire 2b-1 de type NAND dont l'une des entrées 10 est commandée également par la variable S.

Le schéma en branches de cette bascule comporte des topographies particulières en ce qui concerne les portes 1b et 2b comme suit:

| | | | **Canal P** | **Canal N** |
|---|---|---|---|---|
| Porte 1a | groupe 1 | | CK série D | C série CK |
| (B) | groupe 2 | | A | A série D |
| | | | | |
| Porte 1b | groupe 1 | (C) | B | B |
| | | | | |
| | groupe 2 | (A) | B | S série B série CK |
| | groupe 3 | (A) | CK | ----- |
| | groupe 4 | (A) | S | ----- |
| | | | | |
| Porte 2a | groupe 1 | | CK série Q | C série CK |
| (NQ) | groupe 2 | | A | A série Q |
| | | | | |
| Porte 2b | groupe 1 | | NQ | S série NQ |
| (Q) | groupe 2 | | S | ----- |

Par conséquent, cette bascule maître-esclave comporte 26 transistors et elle est également dépourvue de course, tout en disposant d'une commande par la variable S.

Les bascules selon les variantes des figures 6A, 6B, 7A et 7B ont la particularité que les transistors commandés respectivement par les variables S et R sont connectés en parallèle dans les branches canal P et en série dans les branches canal N. Ainsi, la vitesse de fonctionnement de ces bascules ne souffre pas de la présence de ces transistors, car trois transistors dans une branche canal N ont à cet égard la même performance que deux transistors dans une branche canal P.

Une autre variante du second mode de réalisation de l'invention (qui n'est pas représentée aux dessins) consiste à combiner dans une même bascule maître-esclave les deux commandes S et R en superposant en quelque sorte les schémas des figures 6A et 7A, d'une part et 6B et 7B d'autre part.

On va se référer maintenant aux figures 8A et 8B pour décrire une autre variante du premier mode de réalisation de l'invention, dérivée du schéma des figures 2A et 2B. Cette variante comporte une commande de mise à zéro de la sortie Q par la variable R active à "1". Cette bascule est différente par rapport aux précédentes variantes du premier mode de réalisation en ce que la porte 1b comporte une porte élémentaire ET 1b-4 dont une première entrée est commandée par la variable CK et dont l'autre entrée reçoit la variable B. La sortie de cette porte ET 1b-4 est raccordée à l'une des entrées d'une porte élémentaire NOR 1b-5 dont l'autre entrée est commandée par la variable R. La sortie de cette porte 1b-5 fournit la variable de transfert A et est raccordée à l'une des entrées respectives des portes élémentaires ET 1a-1 et 1a-2.

Le schéma en branches de cet élément de mémoire est le suivant :

| | | **Canal P** | **Canal N** |
|---|---|---|---|
| Porte 1a | groupe 1 | CK série D | A série CK |
| (B) | groupe 2 | A | A série D |
| Porte 1b | groupe 1 | B série R | B série CK |
| (A) | groupe 2 | CK série R | R |
| | | | |
| Porte 2a | groupe 1 | CK série Q | A série CK |
| (NQ) | groupe 2 | A | A série Q |
| | | | |
| Porte 2b | groupe 1 | NQ | NQ |
| (Q) | | | |

Cette variante ne comporte que vingt trois transistors, mais elle présente une course critique qu'il faut éliminer par un dimensionnement adéquat des transistors. Bien entendu, pour obtenir une commande R active à zéro, il faut prévoir un inverseur sur la variable R ce qui porte le nombre de transistors à vingt cinq.

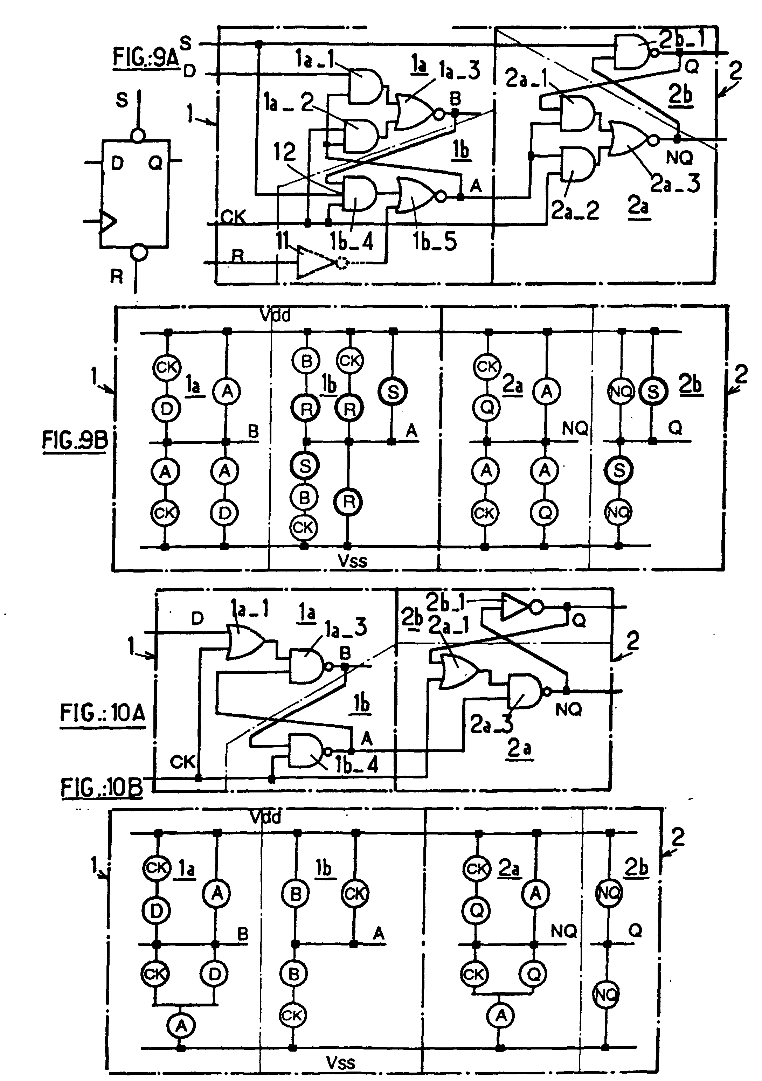

Les figures 9A et 9B représentent une variante dérivée également du premier mode de réalisation de l'invention. Cette variante comporte des commandes R et S actives à "0" (en l'absence de l'inverseur 11 représenté en pointillés). Pour ce qui concerne la commande par la variable R, le schéma fonctionnel de cette variante est identique à celui de la figure 8A, à ceci près que la porte élémentaire NAND 1b-4 comporte une troisième entrée 12 qui est commandée par la variable S. Par ailleurs, dans l'esclave 2, la porte 2b comporte une porte élémentaire NAND 2b-1 à deux entrées dont l'une est également commandée par la variable S.

Cette variante comporte vingt sept transistors et si on souhaite travailler avec une variable R active à "1", il convient de prévoir l'inverseur 11, ce qui augmente le nombre de transistors à vingt neuf.

Le schéma en branches de la figure 9B montre la topographie de cette variante qui est conçue comme suit :

| | | **Canal P** | **Canal N** |
|---|---|---|---|
| Porte 1a | groupe 1 | CK série D | A série CK |
| (B) | groupe 2 | A | A série D |
| | | | |
| Porte 1b | groupe 1 | B série R | S série B série CK |
| (A) | groupe 2 | CK série R | R |
| | groupe 3 | S | ----- |
| | | | |
| Porte 2a | groupe 1 | CK série Q | A série CK |
| (NQ) | groupe 2 | A | A série Q |
| Porte 2b | groupe 1 | NQ | S série NQ |
| (Q) | groupe 2 | S | ----- |

Dans les variantes des figures 3A - 3B, 4A - 4B, 8A-8B et 9A - 9B, les branches canal N des portes la et 2a comportent deux transistors A en parallèle. Selon une autre variante dérivée de la bascule des figures 3A et 3B et représentée sur les figures 10A et 10B, on montre que ces transistors peuvent être remplacés par un seul transistor A permettant ainsi une économie de transistors, cependant que le schéma n'est plus entièrement constitué de branches. Le schéma fonctionnel de la bascule prend alors un aspect un peu différent quoique les fonctionnalités restent les mêmes.

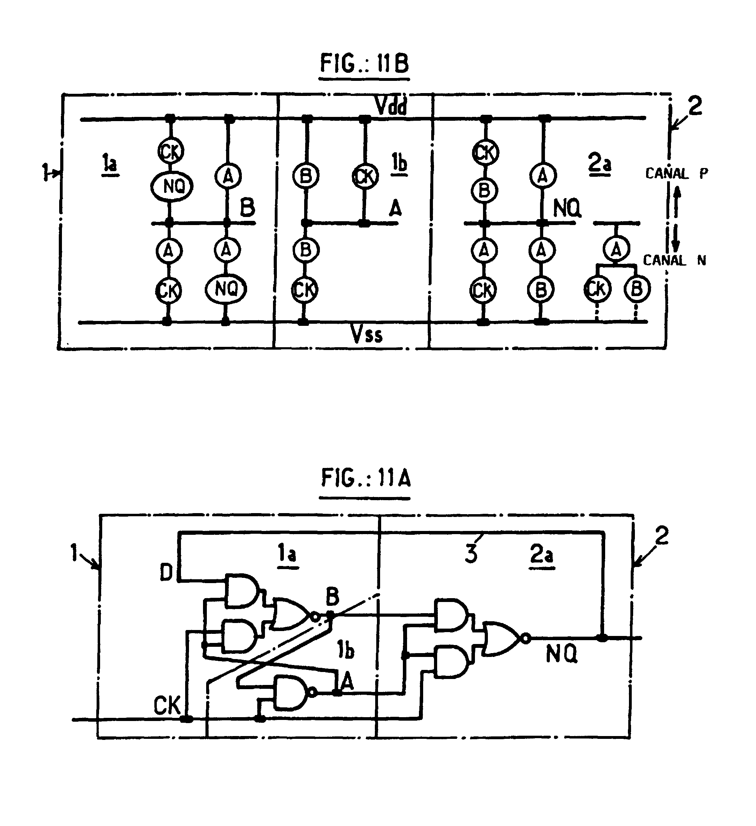

Les figures 11A et 11B montrent une variante du diviseur par 2 des figures 3A et 3B dans laquelle, comme dans ces figures, la variable de sortie NQ est ramenée à l'entrée D de la bascule maître 1. Cependant, par rapport aux figures 3A et 3B, il est possible de supprimer la porte 2b, car on peut utiliser directement la variable NQ comme variable de fréquence deux fois inférieure à celle de la variable CK contrairement à une bascule D où on doit en général disposer de la variable Q.

La figure 11A montre donc ce schéma où la bascule esclave ne comporte que la porte 2a, celle-ci recevant comme variable d'entrée la variable de transfert B provenant de la porte 1a.

Cet élément comporte des courses critiques qui peuvent être évitées si la variable A est plus rapide que la variable B, laquelle à son tour doit etre plus rapide que la variable NQ. Cependant, cet élément ne présente que 18 transistors, nombre que l'on peut réduire à 16 si les deux transistors A dans la porte 2a sont remplacés par un seul transistor.

On voit donc que l'invention propose un certain nombre de configurations d'une bascule D maître-esclave permettant d'obtenir soit une absence totale de course soit une course à laquelle il peut être remédiée par un dimensionnement adéquat des transistors, facile à obtenir. En faisant pencher le compromis évoqué ci-dessus en faveur d'une absence de course, on consent à sacrifier quelque peu la rapidité de fonctionnement le faible encombrement et/ou de faible consommation. En revanche, en admettant une certaine course critique, on peut obtenir une réduction en surface (encombrement) de jusqu'à 20%, une faible consommation et une augmentation de la rapidité de fonctionnement. Le concepteur préférera l'un ou l'autre compromis lors de la conception des circuits intégrés devant comporter des bascules de type D qui ont été décrites ci-dessus.

## Revendications

1. Elément de mémoire du type bascule maître-esclave statique réalisé en technique CMOS et propre à transférer une variable logique d'entrée (D) sur une sortie vraie (Q) et une sortie complémentaire (NQ) de l'élément sous la commande d'un signal d'horloge (CK), ledit élément comportant une bascule maître (1) destinée à commander une bascule esclave (2) par l'intermédiaire d'au moins une variable de transfert (A), ladite bascule esclave (2) étant composée d'une première porte (2a) commandée par ladite au moins une variable de transfert (A), ledit signal d'horloge (CK) et ladite variable de sortie vraie (Q), pour délivrer ladite variable de sortie complémentaire (NQ), et une seconde porte (2b) commandée par ladite variable de sortie complémentaire (NQ) et délivrant ladite variable de sortie vraie (Q), ladite bascule maître (1) comportant une première porte (1a) commandée par ladite variable d'entrée (D), ledit signal d'horloge (CK) et au moins une troisième variable qui est formée par ladite au moins une variable de transfert (A), ladite bascule maître (1) comportant également une seconde porte (1b) de type inverseuse commandée par la sortie (B) de ladite première porte (1a) de la bascule maître (1) et délivrant au moins l'une desdites variables de transfert (A), ledit élément de mémoire étant **caractérisé en ce que** ladite première porte (2a) de ladite bascule esclave (2) comporte un circuit logique constitué de sept transistors qui forment une première porte AND (2a-1) recevant ladite variable de transfert (A) et le signal d'horloge (CK), une deuxième porte AND (2a-2) recevant ladite variable de sortie vraie (Q) et le signal d'horloge (CK), et une part NOR (2a-3) recevant les sorties desdites première et deuxième portes AND pour délivrer ladite variable de sortie complémentaire (NQ).

2. Elément de mémoire suivant la revendication 1, **caractérisé en ce que** ladite seconde porte de type inverseuse (1b) de la bascule maître (1) comporte une porte de type NAND (1b-1) dont une première entrée est commandée par la sortie (B) de ladite première porte (1a) de la bascule maître (1), dont une seconde entrée est commandée par ledit signal d'horloge (CK) et dont la sortie est rebouclée sur ladite première porte (1a) de la bascule maître (1), tout en formant l'unique sortie délivrant une variable de transfert (A).

3. Elément de mémoire suivant la revendication 2, **caractérisé en ce qu'**il est réalisé selon un schéma en branches qui présente la forme suivante :
| | | **Canal P** | **Canal N** |
|---|---|---|---|
| Porte 1a | groupe 1 | CK série D | A série CK |
| (B) | groupe 2 | A | A série D |
| | | | |
| Porte 1b | groupe 1 | B | B série CK |
| (A) | groupe 2 | CK | ----- |
| | | | |
| Porte 2a | groupe 1 | CK série Q | A série CK |
| (NQ) | groupe 2 | A | A série Q |
| | | | |
| Porte 2b | groupe 1 | NQ | NQ |
| (Q) | | | |

4. Elément de mémoire suivant la revendication 2, **caractérisé en ce qu'**il constitue un diviseur par deux et **en ce qu'**à cet effet, ladite sortie complémentaire (NQ) est rebouclée (connexion 3) sur l'entrée de ladite première porte (1a) de la bascule maître (1) en tant que ladite variable d'entrée (D=NQ) (figures 3A et 3B).

5. Elément de mémoire suivant la revendication 4, **caractérisé en ce qu'**il est réalisé selon un schéma en branches qui présente la forme suivante :
| | | **Canal P** | **Canal N** |
|---|---|---|---|
| Porte 1a | groupe 1 | CK série NQ | A série CK |
| (B) | groupe 2 | A | A série NQ |
| | | | |
| Porte 1b | groupe 1 | B | B série CK |
| (A) | groupe 2 | CK | ---- |
| Porte 2a | groupe 1 | CK série Q | A série CK |
| (NQ) | groupe 2 | A | A série Q |
| | | | |
| Porte 2b | groupe 1 | NQ | NQ |
| (Q) | | | |

6. Elément de mémoire suivant la revendication 2, **caractérisé en ce qu'**il comprend également une commande (S) de mise à "1" de ladite sortie vraie (Q) et en ce ladite seconde porte (1b) de la bascule maître (1) et ladite seconde porte (2b) de ladite bascule esclave (2) comportent chacune une entrée supplémentaire (4, 5) recevant ladite commande de mise à "1" (S) .

7. Elément de mémoire suivant la revendication 6, **caractérisé en ce qu'**il est réalisé selon un schéma en branches qui présente la forme suivante:
| | | **Canal P** | **Canal N** |
|---|---|---|---|
| Porte 1a | groupe 1 | CK série D | A série CK |
| (B) | groupe 2 | A | A série D |
| | | | |
| Porte 1b | groupe 1 | B | S série B série CK |
| (A) | groupe 2 | CK | ----- |
| | groupe 3 | S | ----- |
| | | | |
| Porte 2a | groupe 1 | CK série Q | A série CK |
| (NQ) | groupe 2 | A | A série Q |
| | | | |
| Porte 2b | groupe 1 | NQ | NQ série S |
| (Q) | groupe 2 | S | ----- |

8. Elément de mémoire suivant la revendication 1, **caractérisé en ce que** ladite seconde porte du type inverseuse (1b) de ladite bascule maître comporte un inverseur élémentaire (1b-2) dont l'entrée est connectée à la sortie (B) de ladite première porte (1a) de cette bascule (1) et dont la sortie est rebouclée pour commander ladite première porte (1a) de la bascule maître (1) tout en fournissant l'une desdites variables de transfert (C), ladite seconde porte du type inverseuse (1b) comprenant également une porte élémentaire de type NAND (1b-3) dont une première entrée est connectée à la sortie (B) de ladite première porte (1a) de la bascule maître (1), dont une seconde entrée est commandée par ledit signal d'horloge (CK) et dont la sortie constitue l'autre variable de transfert (A) pour ladite bascule esclave (2), tout en étant également rebouclée pour commander ladite première porte (1a) de ladite bascule maître (1).

9. Elément de mémoire suivant la revendication 8, **caractérisé en ce qu'**il est réalisé selon une schéma en branches qui présente la forme suivante :
| | | | **Canal P** | **Canal N** |
|---|---|---|---|---|
| Porte 1a | groupe 1 | | CK série D | C série CK |
| (B) | groupe 2 | | A | A série D |
| | | | | |
| Porte 1b | groupe 1 | (C) | B | B |
| | | | | |
| | groupe 2 | (A) | B | B série CK |
| | groupe 3 | (A) | CK | ----- |
| | | | | |
| Porte 2a | groupe 1 | | CK série Q | C série CK |
| (NQ) | groupe 2 | | A | A série Q |
| | | | | |
| Porte 2b | groupe 1 | | NQ | NQ |
| (Q) | | | | |

10. Elément de mémoire suivant la revendication 8, **caractérisé en ce qu'**il comprend également une commande (R) de mise à "0" de ladite sortie vraie (Q) et en ce ladite première porte (1a) de la bascule maître (1) et ladite première porte (2a) de ladite bascule esclave (2) comportent chacune une entrée supplémentaire (7, 8) recevant ladite commande de mise à "0" (R).

11. Elément de mémoire suivant la revendication 10, **caractérisé en ce qu'**il est réalisé sous la forme d'un schéma en branches qui présente la forma suivante :
| | | | **Canal P** | **Canal N** |
|---|---|---|---|---|
| Porte 1a | groupe 1 | | R | ----- |
| (B) | groupe 2 | | CK série D | R série C série CK |
| | groupe 3 | | A | R série A série D |
| | | | | |
| Porte 1b | groupe 1 | (C) | B | B |
| | | | | |
| | groupe 2 | (A) | B | B série CK |
| | groupe 3 | (A) | CK | ----- |
| | | | | |
| Porte 2a | groupe 1 | | R | ----- |
| (NQ) | groupe 2 | | CK série Q | C série CK |
| | groupe 3 | | A | R série A série Q |
| | | | | |
| Porte 2b | groupe 1 | | NQ | NQ |
| (Q) | | | | |

12. Elément de mémoire suivant la revendication 8, **caractérisé en ce qu'**il comprend également une commande (S) de mise à "1" de ladite sortie vraie (Q) et en ce ladite seconde porte (1b) de la bascule maître (1) et ladite seconde porte (2b) de ladite bascule esclave (2) comportent chacune une entrée supplémentaire (9, 10) recevant ladite commande de mise à "1" (S).

13. Elément de mémoire suivant la revendication 12, **caractérisé en ce qu'**il est réalisé selon un schéma en branches qui présente la forme suivante :
| | | | **Canal P** | **Canal N** |
|---|---|---|---|---|
| Porte 1a | groupe 1 | | CK série D | C série CK |
| (B) | groupe 2 | | A | A série D |
| | | | | |
| Porte 1b | groupe 1 | (C) | B | B |
| | | | | |
| | groupe 2 | (A) | B | S série B série CK |
| | groupe 3 | (A) | CK | ----- |
| | groupe 4 | (A) | S | ----- |
| | | | | |
| Porte 2a | groupe 1 | | CK série Q | C série CK |
| (NQ) | groupe 2 | | A | A série Q |
| | | | | |
| Porte 2b | groupe 1 | | NQ | S série NQ |
| (Q) | groupe 2 | | S | ----- |

14. Elément de mémoire suivant la revendication 8, **caractérisé en ce qu'**il présente en combinaison les schémas en branches selon les revendications 11 et 13, les éléments logiques élémentaires identiques de ces schémas n'étant utilisés qu'une seule fois.

15. Elément de mémoire suivant la revendication 1, **caractérisé en ce que** ladite seconde porte de type inverseuse (1b) de la bascule maître (1) comporte une porte de type ET (1b-4) dont une première entrée est commandée par la sortie (B) de ladite première porte (1a) de la bascule maître (1), dont une seconde entrée est commandée par ledit signal d'horloge (CK) et dont la sortie commande la première entrée d'une porte de type NOR (1b-5) dont l'autre entrée est commandée par un signal (R) de mise à "0" de ladite sortie vraie (Q), la sortie de cette porte NOR (1b-5) étant rebouclée sur ladite première porte (1a) de la bascule maître (1) et fournissant ladite variable de transfert (A).

16. Elément de mémoire suivant la revendication 15, **caractérisé en ce qu'**il est réalisé selon un schéma en branches qui présente la forme suivante:
| | | **Canal P** | **Canal N** |
|---|---|---|---|
| Porte 1a | groupe 1 | CK série D | A série CK |
| (B) | groupe 2 | A | A série D |
| | | | |
| Porte 1b | groupe 1 | B série R | B série CK |
| (A) | groupe 2 | CK série R | R |
| | | | |
| Porte 2a | groupe 1 | CK série Q | A série CK |
| (NQ) | groupe 2 | A | A série Q |
| | | | |
| Porte 2b | groupe 1 | NQ | NQ |
| (Q) | | | |

17. Elément de mémoire suivant la revendication 15, **caractérisé en ce qu'**il comprend également une commande (S) de mise à "1" de ladite sortie vraie (Q) , et en ce ladite seconde porte (1b) de la bascule maître (1) et ladite seconde porte (2b) de ladite bascule esclave (2) comportent chacune une entrée supplémentaire (4, 5) recevant ladite commande de mise à "1" (S).

18. Elément de mémoire suivant la revendication 17, **caractérisé en ce qu'**il est réalisé selon un schéma en branches qui présente la forme suivante :
| | | **Canal P** | **Canal N** |
|---|---|---|---|
| Porte 1a | groupe 1 | CK série D | A série CK |
| (B) | groupe 2 | A | A série D |
| | | | |
| Porte 1b | groupe 1 | B série R | S série B série CK |
| (A) | groupe 2 | CK série R | R |
| | groupe 3 | S | ----- |
| Porte 2a | groupe 1 | CK série Q | A série CK |
| (NQ) | groupe 2 | A | A série Q |
| | | | |
| Porte 2b | groupe 1 | NQ | S série NQ |
| (Q) | groupe 2 | S | ----- |

19. Elément de mémoire suivant l'une quelconque des revendications 3, 5, 7, 16 et 18, **caractérisé en ce que** dans le cas où des branches parallèles d'une même porte (la, 2a) doivent comporter des transistors commandés par la même variable (A), ces transistors sont réalisés au moyen d'un seul transistor (A) formant un trajet série commun sur ces branches parallèles.

20. Elément de mémoire du type bascule maître-esclave statique, réalisé en technique CMOS et propre à délivrer une variable logique de sortie (NQ) qui est la division par deux d'une variable logique d'entrée (CK), ledit élément comportant une bascule maître (1) destinée à commander une bascule esclave (2) par l'intermédiaire de variables de transfert (A, B), ladite bascule esclave (2) étant composée d'une porte (2a) commandée par lesdites variables de transfert (A, B) et ladite variable logique d'entrée (CK), pour délivrer ladite variable de sortie (NQ), ladite bascule maître (1) comportant une première porte (la) commandée par ladite variable d'entrée (CK) et une autre variable (D) formée par ladite variable de sortie (NQ) rebouclée, ladite bascule maître (1) comportant également une seconde porte (1b) de type inverseuse commandée par la sortie (B) de ladite première porte (1a) de la bascule maître (1) et ladite variable d'entrée (CK) pour délivrer l'une desdites variables de transfert (A, B), ledit élément de mémoire étant **caractérisé en ce que** ladite porte (2a) de ladite bascule esclave (2) comporte un circuit logique constitué de sept transistors qui forment une premiere porte ANP (2a-1) recevant ladite variable de transfert (A) et le signal d'horloge (CK), une deuxième porte AND (2a-2) recevant ladite variable de sortie vraie (Q) et le signal d'horloge (CK), et une port NOR (2a-3) recevant les sorties desdites première et deuxième portes AND pour dèlivrer ladite variable de sortie complémentaire (NQ).

21. Elément de mémoire suivant la revendication 20, **caractérisé en ce qu'**il est réalisé selon un schéma en branches qui présente la forme suivante :
| | | **Canal P** | **Canal N** |
|---|---|---|---|
| Porte 1a | groupe 1 | CK série NQ | A série CK |
| (B) | groupe 2 | A | A série NQ |
| Porte 1b | groupe 1 | B | B série CK |
| (A) | groupe 2 | CK | ---- |
| | | | |
| Porte 2a | groupe 1 | CK série Q | A série CK |
| (NQ) | groupe 2 | A | A série Q |

22. Elément de mémoire suivant la revendication 21, **caractérisé en ce que** les branches parallèles (CK, B) de ladite porte (2a) de ladite bascule esclave (2) comportent un seul transistor commandé par l'une desdites variables de transfert (A) et formant un trajet série commun sur ces branches parallèles.

## Patentansprüche

1. Speicherelement vom Typ der statischen Master-Slave-Kippschaltung, die in CMOS-Technik ausgeführt ist und zum Übertragen einer logischen Eingangsveränderlichen (D) auf einen echten Ausgang (Q) und einen komplementären Ausgang (NQ) des Speicherelementes unter der Steuerung eines Zeitgebersignals (CK) dient, wobei das Speicherelement eine Master-Kippschaltung (1) zum Steuern einer Slave-Kipp-schaltung (2) mittels mindestens einer Übertragungsveränderlichen (A) aufweist, wobei die Slave-Kippschaltung (2) zusammengesetzt ist aus einem ersten Tor (2a), das durch die mindestens eine Übertragungsveränderliche (A), das Zeitgebersignal (CK) und die Veränderliche des echten Ausgangs (Q) gesteuert wird, um die Veränderliche des komplementären Ausgangs (NQ) abzugeben, und einem zweiten Tor (2b), das von der Veränderlichen des komplementären Ausgangs (NQ) gesteuert wird und die Veränderliche des echten Ausgangs (Q) abgibt, wobei die Master-Kippschaltung (1) einen ersten Tor (1a) aufweist, das von der Eingangsveränderlichen (D), dem Zeitgebersignal (CK) und mindestens einer dritten Veränderlichen gesteuert wird, die von der mindestens einen Übertragungsveränderlichen gebildet wird, wobei die Master-Kippschaltung (1) ferner ein zweites Tor (1b) des Invertertyps aufweist, das von dem Ausgang (B) des ersten Tores (1a) der Master-Kippschaltung (1) gesteuert wird und mindestens die eine der Übertragungsveränderlichen (A) abgibt, wobei das Speicherelement **dadurch gekennzeichnet ist, dass** das erste Tor (2a) der Slave-Kippschaltung (2) eine Logikschaltung aufweist, die aus sieben Transistoren aufgebaut ist, welche ein erstes AND-Tor (2a-1), das die Übertragungsveränderliche (A) und das Zeitgebersignal (CK) empfängt, ein zweites AND-Tor (2a-2), das die Veränderliche des echten Ausgangs (Q) und das Zeitgebersignal (CK) empfängt, und ein NOR-Tor (2a-3), das die Ausgänge des ersten und zweiten AND-Tores empfängt, bilden, um die Veränderliche des komplementären Ausgangs (NQ) abzugeben.

2. Speicherelement nach Anspruch 1, **dadurch gekennzeichnet, dass** das zweite Tor des Invertertyps (1b) der Master-Kippschaltung (1) ein Tor des NAND-Typs (1b-1) aufweist, von dem ein erster Eingang durch den Ausgang (B) des ersten Tores (1a) der Master-Kippschaltung (1) gesteuert wird, von dem ein zweiter Eingang durch das Zeitgebersignal (CK) gesteuert wird und dessen Ausgang auf das erste Tor (1a) der Master-Kippschaltung (1) rückgekoppelt ist, wobei es den einzigen Ausgang bildet, der eine Übertragungsveränderliche (A) abgibt.

3. Speicherelement nach Anspruch 2, **dadurch gekennzeichnet, dass** es nach einem Verzweigungsschema ausgeführt ist, das die folgende Form hat:
| | | P-Kanal | N-Kanal |
|---|---|---|---|
| Tor 1a | Gruppe 1 | CK Serie D | A Serie CK |
| (B) | Gruppe 2 | A | A Serie D |
| | | | |
| Tor 1b | Gruppe 1 | B | B Serie CK |
| (A) | Gruppe 2 | CK | --------- |
| | | | |
| Tor 2a | Gruppe 1 | CK Serie Q | A Serie CK |
| (NQ) | Gruppe 2 | A | A Serie Q |
| | | | |
| Tor 2b | Gruppe 1 | NQ | NQ |
| (Q) | | | |

4. Speicherelement nach Anspruch 2, **dadurch gekennzeichnet, dass** es einen durch zwei teilenden Divisor bildet und dass zu diesem Zweck der komplementäre Ausgang (NQ) auf den Eingang des ersten Tores (1a) der Master-Kippschaltung (1) als die Eingangsveränderliche (D=NQ) rückgekoppelt (Verbindung 3) ist (Figuren 3A und 3B).

5. Speicherelement nach Anspruch 4, **dadurch gekennzeichnet, dass** es nach einem Verzweigungsschema ausgeführt ist, das die folgende Form hat:
| | | P-Kanal | N-Kanal |
|---|---|---|---|
| Tor 1a | Gruppe 1 | CK Serie NQ | A Serie CK |
| (B) | Gruppe 2 | A | A Serie NQ |
| | | | |
| Tor 1b | Gruppe 1 | B | B Serie CK |
| (A) | Gruppe 2 | CK | --------- |
| | | | |
| Tor 2a | Gruppe 1 | CK Serie Q | A Serie CK |
| (NQ) | Gruppe 2 | A | A Serie Q |
| | | | |
| Tor 2b | Gruppe 1 | NQ | NQ |
| (Q) | | | |

6. Speicherelement nach Anspruch 2, **dadurch gekennzeichnet, dass** es ferner einen Steuerbefehl (S) zum 1-Setzen des echten Ausgangs (Q) aufweist, und dass das zweite Tor (1b) der Master-Kippschaltung (1) und das zweite Tor (2b) der Slave-Kippschaltung (2) jeweils einen zusätzlichen Eingang (4, 5) aufweisen, das den Steuerbefehl (S) zum 1-Setzen empfängt.

7. Speicherelement nach Anspruch 6, **dadurch gekennzeichnet, dass** es nach einem Verzweigungsschema ausgeführt ist, das die folgende Form hat:
| | | P-Kanal | N-Kanal |
|---|---|---|---|
| Tor 1a | Gruppe 1 | CK Serie D | A Serie CK |
| (B) | Gruppe 2 | A | A Serie D |
| | | | |
| Tor 1b | Gruppe 1 | B | S Serie B Serie CK |
| (A) | Gruppe 2 | CK | --------- |
| | Gruppe 3 | S | --------- |
| | | | |
| Tor 2a | Gruppe 1 | CK Serie Q | A Serie CK |
| (NQ) | Gruppe 2 A | A Serie Q | |
| | | | |
| Tor 2b | Gruppe 1 | NQ | NQ Serie S |
| (Q) | Gruppe 2 | S | ----- |

8. Speicherelement nach Anspruch 1, **dadurch gekennzeichnet, dass** das zweite Tor des Invertertyps (1b) der Master-Kippschaltung einen elementaren Inverter (1b-2) aufweist, dessen Eingang mit dem Ausgang (B) des ersten Tores (1a) dieser Kippschaltung ( 1 ) verbunden ist und dessen Ausgang rückgekoppelt ist, um das erste Tor (1a) der Master-Kippschaltung (1) zu steuern, während es die eine der Übertragungsveränderlichen (C) abgibt, wobei das zweite Tor des Invertertyps (1b) ebenfalls ein elementares Tor des NAND-Typs (1b-3) aufweist, von dem ein erster Eingang mit dem Ausgang (B) des ersten Tores (1a) der Master-Kippschaltung (1) verbunden ist, von dem ein zweiter Eingang durch das Zeitgebersignal (CK) gesteuert wird und dessen Ausgang die andere Übertragungsveränderliche (A) für die Slave-Kippschaltung (2) bildet, wobei es ebenfalls rückgekoppelt ist, um das erste Tor (1a) der Master-Kippschaltung ( 1 ) zu steuern.

9. Speicherelement nach Anspruch 8, **dadurch gekennzeichnet, dass** es nach einem Verzweigungsschema ausgeführt ist, das die folgende Form hat:
| | | | P-Kanal | N-Kanal |
|---|---|---|---|---|
| Tor 1a | Gruppe 1 | | CK Serie D | C Serie CK |
| (B) | Gruppe 2 | | A | A Serie D |
| | | | | |
| Tor 1b | Gruppe 1 | (C) | B | B |
| | | | | |
| | Gruppe 2 | (A) | B | B Serie CK |
| | Gruppe 3 | (A) | CK | -------- |
| | | | | |
| Tor 2a | Gruppe 1 | | CK Serie Q | C Serie CK |
| (NQ) | Gruppe 2 | | A | A Serie Q |
| | | | | |
| Tor 2b | Gruppe 1 | | NQ | NQ |
| (Q) | | | | |

10. Speicherelement nach Anspruch 8, **dadurch gekennzeichnet, dass** es ferner einen Steuerbefehl (R) zum 0-Setzen des echten Ausgangs (Q) aufweist und dass das erste Tor (1a) der Master-Kippschaltung (1) und das erste Tor (2a) der Slave-Kippschaltung (2) jeweils einen zusätzlichen Eingang (7, 8) aufweisen, der den Steuerbefehl (R) zum 0-Setzen empfängt.

11. Speicherelement nach Anspruch 10, **dadurch gekennzeichnet, dass** es in Form eines Verzweigungsschemas ausgeführt ist, das die folgende Form hat:
| | | | P-Kanal | N-Kanal |
|---|---|---|---|---|
| Tor 1a | Gruppe 1 | | R | ------- |
| (B) | Gruppe 2 | | CK Serie D | R Serie C Serie CK |
| | Gruppe 3 | | A | R Serie A Serie D |
| | | | | |
| Tor 1b | Gruppe 1 | (C) | B | B |
| | | | | |
| | Gruppe 2 | (A) | B | B Serie CK |
| | Gruppe 3 | (A) | CK | ------- |
| | | | | |
| Tor 2a | Gruppe 1 | | R | ------- |
| (NQ) | Gruppe 2 | | CK Serie Q | C Serie CK |
| | Gruppe 3 | | A | R Serie A Serie Q |
| | | | | |
| Tor 2b | Gruppe 1 | | NQ | NQ |
| (Q) | | | | |

12. Speicherelement nach Anspruch 8, **dadurch gekennzeichnet, dass** es ferner einen Steuerbefehl (S) zum 1-Setzen des echten Ausgangs (Q) aufweist und dass das zweite Tor (1b) der Master-Kippschaltung (1) und das zweite Tor (2b) der Slave-Kippschaltung (2) jeweils einen zusätzlichen Eingang (9, 10) aufweisen, der den Steuerbefehl (S) zum 1-Setzen empfängt.

13. Speicherelement nach Anspruch 12, **dadurch gekennzeichnet, dass** es nach einem Verzweigungsschema ausgeführt ist, das die folgende Form hat:
| | | | P-Kanal | N-Kanal |
|---|---|---|---|---|
| Tor 1a | Gruppe 1 | | CK Serie D | C Serie CK |
| (B) | Gruppe 2 | | A | A Serie D |
| | | | | |
| Tor 1b | Gruppe 1 | (C) | B | B |
| | | | | |
| | Gruppe 2 | (A) | B | S Serie B Serie CK |
| | Gruppe 3 | (A) | CK | --------- |
| | Gruppe 4 | (A) | S | --------- |
| | | | | |
| Tor 2a | Gruppe 1 | | CK Serie Q | S Serie CK |
| (NQ) | Gruppe 2 | | A | A Serie Q |
| | | | | |
| Tor 2b | Gruppe 1 | | NQ | S Serie NQ |
| (Q) | Gruppe 2 | | S | --------- |

14. Speicherelement nach Anspruch 8, **dadurch gekennzeichnet, dass** es in Kombination die Verzweigungsschemas nach den Ansprüchen 11 und 13 aufweist, wobei die identischen elementaren Logikelemente dieser Schemas nur ein einziges Mal verwendet werten.

15. Speicherelement nach Anspruch 1, **dadurch gekennzeichnet, dass** das zweite Tor des Invertertyps (1b) der Master-Kippschaltung (1) ein Tor des ET-Typs (1b-4) aufweist, von dem ein erster Eingang durch den Ausgang (B) des ersten Tores (1a) der Master-Kippschaltung (1) gesteuert wird, von dem ein zweiter Eingang durch das Zeitgebersignal (CK) gesteuert wird und dessen Ausgang den ersten Eingang eines Tores des NOR-Typs (1b-5) steuert, dessen anderer Eingang durch ein Signal (R) zum 0-Setzen des echten Ausgangs (Q) gesteuert wird, wobei der Ausgang dieses NOR-Tores (1b-5) auf das erste Tor (1a) der Master-Kippschaltung (1) rückgekoppelt ist und die Übertragungsveränderliche abgibt.

16. Speicherelement nach Anspruch 15, **dadurch gekennzeichnet, dass** es nach einem Verzweigungsschema ausgeführt ist, das die folgende Form hat:
| | | P-Kanal | N-Kanal |
|---|---|---|---|
| Tor 1a | Gruppe 1 | CK Serie D | A Serie CK |
| (B) | Gruppe 2 | A | A Serie D |
| | | | |
| Tor 1b | Gruppe 1 | B Serie R | B Serie CK |
| (A) | Gruppe 2 | CK Serie R | R |
| | | | |
| Tor 2a | Gruppe 1 | CK Serie Q | A Serie CK |
| (NQ) | Gruppe 2 | A | A Serie Q |
| | | | |
| Tor 2b | Gruppe 1 | NQ | NQ |
| (Q) | | | |

17. Speicherelement nach Anspruch 15, **dadurch gekennzeichnet, dass** es ferner einen Steuerbefehl (S) zum 1-Setzen des echten Ausgangs (Q) aufweist und dass das zweite Tor (1b) der Master-Kippschaltung (1) und das zweite Tor (2b) der Slave-Kippschaltung (2b) einen zusätzlichen Eingang (4, 5) aufweisen, der den Steuerbefehl (S) zum 1-Setzen empfängt.

18. Speicherelement nach Anspruch 17, **dadurch gekennzeichnet, dass** es nach einem Verzweigungsschema ausgeführt ist, das die folgende Form hat:
| | | P-Kanal | N-Kanal |
|---|---|---|---|
| Tor 1a | Gruppe 1 | CK Serie D | A Serie CK |
| (B) | Gruppe 2 | A | A Serie D |
| | | | |
| Tor 1b | Gruppe 1 | B Serie R | S Serie B Serie CK |
| (A) | Gruppe 2 | CK Serie R | R |
| | Gruppe 3 | S | --------- |
| | | | |
| Tor 2a | Gruppe 1 | CK Serie Q | A Serie CK |
| (NQ) | Gruppe 2 | A | A Serie Q |
| | | | |
| Tor 2b | Gruppe 1 | NQ | S Serie NQ |
| (Q) | Gruppe 2 | S | --------- |

19. Speicherelement nach einem der Ansprüche 3, 5, 7, 16 und 18, **dadurch gekennzeichnet, dass** für den Fall, dass parallele Zweige eines selben Tores (1a, 2a) von derselben Veränderlichen (A) gesteuerte Transistoren enthalten müssen, diese Transistoren mittels eines einzigen Transistors (A) ausgeführt sind, der einen gemeinsamen seriellen Pfad auf diesen parallelen Zweigen bildet.

20. Speicherelement vom Typ der statischen Master-Slave-Kippschaltung, das in CMOS-Technik ausgeführt ist und zum Abgeben einer logischen Ausgangsveränderlichen (NQ) dient, die die Zweiteilung einer logischen Eingangsveränderlichen (CK) ist, wobei das Speicherelement eine Master-Kippschaltung (1) zum Steuern einer Slave-Kippschaltung (2) mittels Übertragungsveränderlichen (A, B) aufweist, die Slave-Kippschaltung (2) aus einem Tor (2a) besteht, das von den Übertragungsveränderlichen (A, B) und der logischen Eingangsveränderlichen (CK) gesteuert wird, um die Ausgangsveränderliche (NQ) abzugeben, wobei die Master-Kippschaltung (1) ein erstes Tor (1a) aufweist, das von der Eingangsveränderlichen (CK) und einer weiteren Veränderlichen (D) gesteuert wird, die von der rückgekoppelten Ausgangsveränderlichen (NQ) gebildet wird, wobei die Master-Kippschaltung (1) ein zweites Tor (1b) des Invertertyps aufweist, das von dem Ausgang (B) des ersten Tores (1a) der Master-Kippschaltung (1) und der Eingangsveränderlichen (CK) gesteuert wird, um die eine der Übertragungsveränderlichen (A, B) abzugeben, wobei das Speicherelement **dadurch gekennzeichnet ist, dass** das Tor (2a) der Slave-Kippschaltung (2) eine Logikschaltung aufweist, die aus sieben Transistoren aufgebaut ist, welche ein erstes AND-Tor (2a-1), das die Übertragungsveränderliche (A) und das Zeitgebersignal (CK) empfängt, ein zweites AND-Tor (2a-2), das die Veränderliche des echten Ausgangs (Q) und das Zeitgebersignal (CK) empfängt, und ein NOR-Tor (2a-3), das die Ausgänge des ersten und zweiten AND-Tores empfängt, bilden, um die Veränderliche des komplementären Ausgangs (NQ) abzugeben.

21. Speicherelement nach Anspruch 20, **dadurch gekennzeichnet, dass** es nach einem Verzweigungsschema ausgeführt, das die folgende Form hat:
| | | P-Kanal | N-Kanal |
|---|---|---|---|
| Tor 1a | Gruppe 1 | CK Serie NQ | A Serie CK |
| (B) | Gruppe 2 | A | A Serie NQ |
| | | | |
| Tor 1b | Gruppe 1 | B | B Serie CK |
| (A) | Gruppe 2 | CK | --------- |
| | | | |
| Tor 2a | Gruppe 1 | CK Serie Q | A Serie CK |
| (NQ) | Gruppe 2 | A | A Serie Q |

22. Speicherelement nach Anspruch 21, **dadurch gekennzeichnet, dass** die parallelen Zweige (CK, B) des Tores (2a) der Slave-Kippschaltung (2) einen einzigen Transistor aufweisen, der von der einen der Übertragungsveränderlichen (A) gesteuert wird und einen gemeinsamen seriellen Pfad auf diesen parallelen Zweigen bildet.

## Claims

1. A memory element of the static master-slave flip-flop type constructed by CMOS art and able to transfer an input logic variable (D) to a true output (Q) and a complementary output (NQ) of the element under the control of a dock signal (CK), said element including a master flip-flop (1) intended to control a slave flip-flop (2) via at least one transfer variable (A), said slave flip-flop (2) consisting of a first gate (2a) controlled by said at least one transfer variable (A), said clock signal (CK) and said true output variable (Q), so as to deliver said complementary output variable (NQ), and a second gate (2b) controlled by said complementary output variable (NQ) and delivering said true output variable (Q), said master flip-flop (1) including a first gate (1a) controlled by said input variable (D), said clock signal (CK) and at least one third variable which is formed by said at least one transfer variable (A), said master flip-flop (1) also including a second gate (1b) of inverting type controlled by the output (B) from said first gate (1a) of the master flip-flop (1) and delivering at least one of said transfer variables (A), said memory element being **characterized in that** said first gate (2a) of said slave flip-flop (2) comprises a logic circuit comprising seven transistors that form a first AND gate (2a-1) receiving said transfer variable (A) and said clock signal (CK), a second AND gate (2a-2) receiving said true output variable (Q) and said clock signal (CK) and a NOR gate (2a-3) receiving the outputs of said first and second AND gates so as to deliver said complementary output variable.

2. The memory element as claimed in claim 1, **characterized in that** said second gate of inverting type (1 b) of the master flip-flop (1) includes a NAND type gate (1b-1), a first input of which is controlled by the output (B) of said first gate (1a) of the master flip-flop (1), a second input of which is controlled by said clock signal (CK) and the output of which is fed back to said first gate (1 a) of the master flip-flop (1), while forming the single output delivering a transfer variable (A).

3. The memory element as claimed in claim 2, **characterized in that** it is built in accordance with a branch diagram which exhibits the following form:
| | | **P Channel** | **N Channel** |
|---|---|---|---|
| Gate 1 a | group 1 | CK serial D | A serial CK |
| (B) | group 2 | A | A serial D |
| | | | |
| Gate 1 b | group 1 | B | B serial CK |
| (A) | group 2 | CK | ---- |
| | | | |
| Gate 2a | group 1 | CK serial Q | A serial CK |
| (NQ) | group 2 | A | A serial Q |
| | | | |
| Gate 2b | group 1 | NQ | NQ |
| (Q) | | | |

4. The memory element as claimed in claim 2, **characterized in that** it constitutes a divider by 2 and **in that** for this purpose, said complementary output (NQ) is fed back (connection 3) to the input of said first gate (1a) of the master flip-flop (1) as said input variable (D=NQ) (figures 3A and 3B).

5. The memory element as claimed in claim 4, **characterized in that** it is constructed in accordance with a branch diagram which exhibits the following form:
| | | **P Channel** | **N Channel** |
|---|---|---|---|
| Gate 1a | group 1 | CK serial NQ | A serial CK |
| (B) | group 2 | A | A serial NQ |
| | | | |
| Gate 1b | group 1 | B | B serial CK |
| (A) | group 2 | CK | ―---- |
| | | | |
| Gate 2a | group 1 | CK serial Q | A serial CK |
| (NQ) | group 2 | A | A serial Q |
| | | | |
| Gate 2b | group 1 | NQ | NQ |
| (Q) | | | |

6. The memory element as claimed in claim 2, **characterized in that** it also comprises a set to "1" command (S) for said true output (Q) and **in that** said second gate (1b) of the master flip-flop (1) and said second gate (2b) of said slave flip-flop (2) each include an additional input (4, 5) which receives said set to "1" command (S).

7. The memory element as claimed in claim 6, **characterized in that** it is constructed in accordance with a branch diagram which exhibits the following form:
| | | **P Channel** | **N Channel** |
|---|---|---|---|
| Gate 1a | group 1 | CK serial D | A serial CK |
| (B) | group 2 | A | A serial D |
| | | | |
| Gate 1b | group 1 | B | S serial B serial CK |
| (A) | group 2 | CK | -------- |
| | group 3 | S | -------- |
| | | | |
| Gate 2a | group 1 | CK serial Q | A serial CK |
| (NQ) | group 2 | A | A serial Q |
| | | | |
| Gate 2b | group 1 | NQ | NQ serial S |
| (Q) | group 2 | S | ----- |

8. The memory element as claimed in claim 1, **characterized in that** said second gate of the inverting type (1b) of said master flip-flop comprises an elementary inverter (1b-2), the input of which is connected to the output (B) of said first gate (1a) of this flip-flop (1) and the output of which is fed back in order to control said first gate (1a) of the master flip-flop (1) while yielding one of said transfer variables (C), said second gate of the inverting type (1 b) also comprising a NAND type elementary gate (1b-3), a first input of which is connected to the output (B) of said first gate (1a) of the master flip-flop (1), a second input of which is controlled by said clock signal (CK) and the output of which constitutes the other transfer variable (A) for said slave flip-flop (2), while also being fed back in order to control said first gate (1a) of said master flip-flop (1).

9. The memory element as claimed in claim 8, **characterized in that** it is constructed in accordance with a branch diagram which exhibits the following form:
| | | | **P Channel** | **N channel** |
|---|---|---|---|---|
| Gate 1a | group 1 | | CK serial D | C serial CK |
| (B) | group 2 | | A | A serial D |
| | | | | |
| Gate 1 b | group 1 | (C) | B | B |
| | group 2 | (A) | B | B serial CK |
| | group 3 | (A) | CK | ---- |
| | | | | |
| Gate 2a | group 1 | | CK serial Q | C serial CK |
| (NQ) | group 2 | | A | A serial Q |
| | | | | |
| Gate 2b | group 1 | | NQ | NQ |
| (Q) | | | | |

10. The memory element as claimed in claim 8, **characterized in that** it also comprises a set to "0" command (R) for said true output (Q) and **in that** said first gate (1a) of the master flip-flop (1) and said first gate (2a) of said slave flip-flop (2) each include an additional input (7, 8) which receives said set to "0" command (R).

11. The memory element as claimed in claim 10, **characterized in that** it is constructed in accordance with a branch diagram which exhibits the following form:
| | | | **P Channel** | **N channel** |
|---|---|---|---|---|
| Gate 1a | group 1 | | R | ---- |
| (B) | group 2 | | CK serial D | R serial C serial CK |
| | group 3 | | A | R serial A serial D |
| | | | | |
| Gate 1b | group 1 | (C) | B | B |
| | group 2 | (A) | B | B serial CK |
| | group 3 | (A) | CK | ---- |
| Gate 2a | group 1 | | R | ---- |
| (NQ) | group 2 | | CK serial Q | C serial CK |
| | group 3 | | A | R serial A serial Q |
| | | | | |
| Gate 2b | group 1 | | NQ | NQ |
| (Q) | | | | |

12. The memory element according to claim 8, **characterized in that** it also comprises a set to "1" command (S) for said true output (Q) and **in that** said second gate (1b) of the master flip-flop (1) and said second gate (2b) of said slave flip-flop (2) each include an additional input (9, 10) which receives said set to "1" command (S).

13. The memory element as claimed in claim 12, **characterized in that** it is constructed in accordance with a branch diagram which exhibits the following form:
| | | | **P Channel** | **N channel** |
|---|---|---|---|---|
| Gate 1a | group 1 | | CK serial D | C serial CK |
| (B) | group 2 | | A | A serial D |
| | | | | |
| Gate 1b | group 1 | (C) | B | B |
| | group 2 | (A) | B | S serial B serial CK |
| | group 3 | (A) | CK | ---- |
| | group 4 | (A) | S | ---- |
| | | | | |
| Gate 2a | group 1 | | CK serial Q | C serial CK |
| (NQ) | group 2 | | A | A serial Q |
| | | | | |
| Gate 2b | group 1 | | NQ | S serial NQ |
| (Q) | group 2 | | S | ---- |
| | | | | |

14. The memory element as claimed in claim 8, **characterized in that** it exhibits in combination the branch diagrams in accordance with claims 11 and 13, the identical elementary logic elements of these diagrams being used only once.

15. The memory element as claimed in claim 1, **characterized in that** said second inverting-type gate (1b) of the master flip-flop (1) includes an AND-type gate (1b-4), a first input of which is controlled by the output (B) of said first gate (1a) of the master flip-flop (1), a second input of which is controlled by said clock signal (CK) and the output of which controls the first input of a NOR-type gate (1b-5), the other input of which is controlled by a set to "0" signal (R) for said true output (Q), the output of this NOR gate (1b-5) being fed back to said first gate (1a) of the master flip-flop (1) and yielding said transfer variable (A).

16. The memory element as claimed in claim 15, **characterized in that** it is constructed in accordance with a branch diagram which exhibits the following form:
| | | **P Channel** | **N Channel** |
|---|---|---|---|
| Gate 1a | group 1 | CK serial D | A serial CK |
| (B) | group 2 | A | A serial D |
| | | | |
| Gate 1b | group 1 | B serial R | B serial CK |
| (A) | group 2 | CK serial R | R |
| | | | |
| Gate 2a | group 1 | CK serial Q | A serial CK |
| (NQ) | group 2 | A | A serial Q |
| | | | |
| Gate 2b | group 1 | NQ | NQ |
| (Q) | | | |

17. The memory element as claimed in claim 15, **characterized in that** it also comprises a set to "1" command (S) for said true output (Q) and **in that** said second gate (1b) of the master flip-flop (1) and said second gate (2b) of said slave flip-flop (2) each include an additional input (4, 5) which receives said set to "1" command (S).

18. The memory element as claimed in claim 17, **characterized in that** it is constructed in accordance with a branch diagram which exhibits the following form:
| | | **P Channel** | **N Channel** |
|---|---|---|---|
| Gate 1a | group 1 | CK serial D | A serial CK |
| (B) | group 2 | A | A serial D |
| | | | |
| Gate 1b | group 1 | B serial R | S serial B serial CK |
| (A) | group 2 | CK serial R | R |
| | group 3 | S | ---- |
| | | | |
| Gate 2a | group 1 | CK serial Q | A serial CK |
| (NQ) | group 2 | A | A serial Q |
| | | | |
| Gate 2b | group 1 | NQ | S serial NQ |
| (Q) | group 2 | S | ---- |

19. The memory element as claimed in any one of claims 3, 5, 7, 16 and 18, **characterized in that** in the case in which parallel branches of one gate (1a, 2a) are to comprise transistors controlled by the same variable (A), these transistors are constructed by means of a single transistor (A) forming a common series path on these parallel branches.

20. A memory element of the static master-stave flip-flop type, constructed by CMOS art and able to deliver an output logic variable (NQ) which is the division by two of an input logic variable (CK), said element including a master flip-flop (1) intended to control a slave flip-flop (2) via transfer variables (A, B), said slave flip-flop (2) consisting of a gate (2a) controlled by said transfer variables (A, B) and said input logic variable (CK), so as to deliver said output variable (NQ), said master flip-flop (1) including a first gate (1a) controlled by said input variable (CK) and another variable (D) formed by said fed-back output variable (NQ), said master flip-flop (1) also including a second gate (1 b) of inverting type controlled by the output (B) of said first gate (1a) of the master flip-flop (1) and said input variable (CK) so as to deliver one of said transfer variables (A, B), said memory element being one in which said gate (2a) of said slave flip-flop (2) comprises a logic circuit comprising seven transistors that form a first AND gate (2a-1) receiving said transfer variable (A) and said clock signal (CK), a second AND gate (2a-2) receiving said true output variable (Q) and said clock signal (CK) and a NOR gate (2a-3) receiving the outputs of said first and second AND gates so as to deliver said complementary output variable.

21. The memory element as claimed in claim 20, **characterized in that** it is constructed in accordance with a branch diagram which exhibits the following form:
| | | **P Channel** | **N Channel** |
|---|---|---|---|
| Gate 1a | group 1 | CK serial NQ | A serial CK |
| (B) | group 2 | A | A serial NQ |
| | | | |
| Gate 1b | group 1 | B | B serial CK |
| (A) | group 2 | CK | ---- |
| | | | |
| Gate 2a | group 1 | CK serial Q | A serial CK |
| (NQ) | group 2 | A | A serial Q |

22. The memory element as claimed in claim 21, **characterized in that** the parallel branches (CK, B) of said gate (2a) of said slave flip-flop (2) comprise a single transistor controlled by one of said transfer variables (A) and forming a common series path on these parallel branches.
